Europäisches Patentamt

European Patent Office

Office européen des brevets

(19)

(11) Veröffentlichungsnummer: **0 009 230**
**B1**

(12) **EUROPÄISCHE PATENTSCHRIFT**

(45) Veröffentlichungstag der Patentschrift: **26.05.82**

(21) Anmeldenummer: **79103493.7**

(22) Anmeldetag: **17.09.79**

(51) Int. Cl.³: **G 01 R 17/10,** G 01 L 1/22, G 01 G 3/12, G 01 G 23/16

(54) Schaltungsanordnung zur Erzeugung einer Prüfspannung.

(30) Priorität: **26.09.78 DE 2841839**

(43) Veröffentlichungstag der Anmeldung:
**02.04.80 Patentblatt 80/7**

(45) Bekanntmachung des Hinweises auf die Patenterteilung:
**26.05.82 Patentblatt 82/21**

(84) Benannte Vertragsstaaten:
**AT BE CH FR GB IT LU NL SE**

(56) Entgegenhaltungen:
**DE - A1 - 2 612 399**
**DE - B - 1 198 577**
**US - A - 3 319 155**

**ARCHIV FÜR TECHNISCHES MESSEN,
Heft 9, 1974 (Blatt V 1372-2) München
ST. KEIL et al.: "Über Methoden und
Gerätetechniken zum Kalibrieren von Meßeinrichtungen mit Dehnungsmeßstreifen-
Meßwertaufnehmern, Teil II" Seite 159 bis
Seite 162**

(73) Patentinhaber: **SIEMENS AKTIENGESELLSCHAFT
Berlin und München
Postfach 22 02 61
D-8000 München 22 (DE)**

(72) Erfinder: **Fritz, Harald, Ing.grad.
Hebelstrasse 5
D-7517 Waldbronn 3 (DE)**
Erfinder: **Schröder, Heinrich, Dipl.-Ing.
Schneidemühlerstrasse 43b
D-7500 Karlsruhe (DE)**

Schaltungsanordnung zur Erzeugung einer Prüfspannung

Die Erfindung bezieht sich auf eine Schaltungsanordnung gemäß dem Oberbegriff des Anspruchs 1. In der DE—A 26 12 399 ist eine Schaltungsanordnung beschrieben, bei der am Eingang der Auswerteschaltung ein Umschalter liegt, mit dem dieser Eingang einerseits an die Meßdiagonale einer Widerstandsbrückenschaltung angeschlossen werden kann und andererseits an Massepotential anlegbar ist. Eine dritte Möglichkeit zur Aufgabe eines Prüfsignals an die Auswerteschaltung sieht vor, den am Eingang der Auswerteschaltung liegenden Schalter an die Speisespannung der Meßbrücke als Referenzspannung anzulegen. Zur Prüfung der Auswerteschaltung muß also deren Verbindung mit der Meßwiderstandsbrückenschaltung mit Hilfe des Eingangsschalters unterbrochen werden. Die Kontaktspannungen des Schalters oder die Offsetspannung eines als Schalter verwendeten Halbleiterschalters können sich der Meßspannung überlagern und so unkontrollierbare Fehler verursachen. Aus der Zeitschrift ATM Archiv für technisches Messen, Blatt V1372—2 (Sept. 1974) S. 159—162 ist weiterhin eine Schaltungsanordsung zur Erzeugung einer Prüfspannung für eine an eine Meßbrücke angeschlossene Auswerteschaltung bekannt, bei der die Speisediagonale der elektrischen Brückenschaltung und die Speisediagonale einer zusätzlichen Brückenschaltung an potentialmäßig voneinander getrennten Quellen liegen und die Meßdiagonalen der beiden Brückenschaltungen in Serie an den Eingangsklemmen der Auswerteschaltung angeschlossen sind und die Prüfspannung einer vorgegebenen Verstimmung der zusätzlichen Brückenschaltung entspricht.

Der Erfindung lag die Aufgabe zugrunde, eine Prüfspannung bereitzustellen, die ohne Unterbrechung der Verbindung der Auswerteschaltung mit der Meßwiderstandsbrückenschaltung an die Auswerteschaltung gelegt werden kann.

Bei einer Schaltungsanordnung der eingangs genannten Art wird diese Aufgabe gemäß der Erfindung durch die im Kennzeichen des Anspruchs 1 genannten Merkmale gelöst. Die vorgeschlagene Schaltungsanordnung schützt die Auswerteschaltung während eines Meßzyklus vor unkontrollierten Spannungen, die von dem Schalter der bekannten Lösung herrühren können.

Ein weiterer Vorteil besteht darin, daß der Wert der Prüfspannung nicht nur von der Verstimmung der zusätzlichen Brückenschaltung, sondern auch von der Anzahl und dem Innenwiderstand der dazu parallelliegenden Meßbrückenschaltungen abhängt. Ändert sich am Innenwiderstand einer der Meßbrückenschaltungen etwas, so ändert sich auch das ausgegebene Prüfsignal. Das Prüfsignal dient also zusätzlich auch der Prüfung der Meßbrücken auf Funktionsfehler.

Die Schaltungsanordnung kann zweckmäßig bei elektrischen Waagen verwendet werden, bei denen die Meßbrückenschaltungen aus Dehnungsmeßstreifen aufgebaut sind und die Auswerteschaltung eine elektronische Auswägeeinrichtung darstellt. In diesem Fall kann die zusätzliche Brückenschaltung auch zur Erzeugung eines sogenannten Totlastsignales eingesetzt werden. Die Erzeugung eines Totlastsignals bei einer Waage mit Hilfe einer zusätzlich zur Dehnungsmeßsteifenbrücke vorgesehenen Brücke ist aus DE—B 1108577 bekannt.

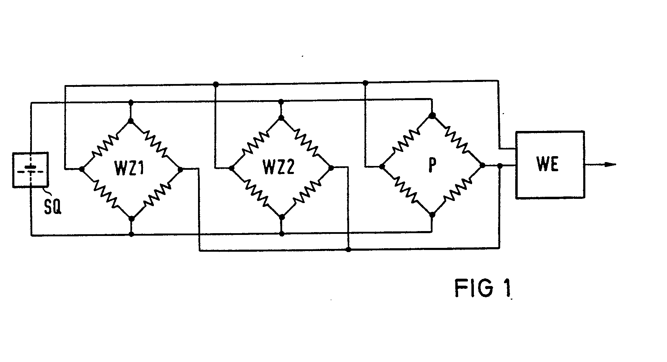

Die Erfindung wird durch die Figur 1 verdeutlicht, die ein Ausführungsbeispiel als Blockschaltbild darstellt.

In Figur 1 liegen zwei Brückenschaltungen WZ1 und WZ2 mit ihren Speisediagonalen parallel an Ausgangsklemmen einer Speisequelle SQ. Die Meßdiagonalen der Brückenschaltungen WZ1 und WZ2 liegen parallel an Eingangsklemmen einer Auswerteschaltung WE. Bei der Auswerteschaltung kann es sich sowohl um eine kompensatorische Meßschaltung für die Diagonalspannungen der Widerstandsbrückenschaltungen als auch um eine Verstärkung mit anschließender Anzeige der Brückenspannung handeln. Eine dritte, zusätzliche Brückenschaltung P liegt mit ihrer Speisediagonalen parallel zu den übrigen Speisediagonalen an den Ausgangsklemmen der Speisequelle SQ und mit ihrer Meßdiagonalen parallel zu den übrigen Meßdiagonalen an den Ausgangsklemmen der Auswerteschaltung WE.

Die Brückenschaltungen WZ1, WZ2 können Wägezellen einer elektrischen Wägeeinrichtung sein.

**Patentansprüche**

1. Schaltungsanordnung zur Erzeugung einer Prüfspannung für eine an die Meßdiagonale mindestens einer elektrischen Meßbrückenschaltung (WZ1 bzw. WZ2) angeschlossene Auswerteschaltung (WE) mit einer der Meßbrückenschaltung speisediagonalseitig parallelgeschalteten zusätzlichen Brückenschaltung (P), dadurch gekennzeichnet, daß auch die Meßdiagonale der zusätzlichen Brückenschaltung (P) der Meßdiagonalen der Meßbrückenschaltung (WZ1 bzw. WZ2) unmittelbar parallelgeschaltet ist.

2. Schaltungsanordnung nach Anspruch 1, dadurch gekennzeichnet, daß die Auswerteschaltung (WE) die Auswägeeinrichtung einer Waage ist und die zusätzliche Brückenschaltung (P) zur Erzeugung eines Totlastsignals dient.

**Revendications**

1. Montage pour produire une tension de contrôle pour un circuit d'évaluation (WE) relié à la diagonale de mesure d'au moins un circuit de mesure électrique en pont (WZ1, WZ2), et comportant un circuit en pont supplémentaire (P) monté en parallèle sur le circuit de mesure en pont, caractérisé par le fait que la diagnonale du circuit en pont supplémentaire (P) est également montée directement en parallèle sur la diagonale de mesure du circuit de mesure en pont (WZ1, WZ2).

2. Montage selon la revendication 1, caractérisé par le fait que le circuit d'évaluation (WE) est constitué par le dispositif de pesée d'une bascule, et que le circuit en pont supplémentaire (P) sert à produire un signal représentatif du poids mort.

**Claims**

1. A circuit arrangement for the generation of a test voltage for an evaluation circuit (WE), connected to the measuring diagonal of at least one electrical measurement bridge circuit (WZ1 and WZ2), and which comprises an additional bridge circuit (P) connected in parallel with the measurement bridge circuit supply diagonal, characterised in that the measuring diagonal of the additional bridge circuit (p) is connected directly in parallel with the measuring diagonal of the measurement bridge circuit (WZ1 and WZ2).

2. A circuit arrangement as claimed in claim 1, characterised in that the evaluation circuit (WE) is the counterbalancing device of a pair of scales and the additional bridge circuit (P) serves to produce a dead load signal.

FIG 1